**Europäisches Patentamt**

**European Patent Office**

**Office européen des brevets**

(19)

(11) Numéro de publication : **0 209 415 B1**

(12) **FASCICULE DE BREVET EUROPÉEN**

(45) Date de publication du fascicule du brevet :
02.11.89

(51) Int. Cl.⁴ : **H 01 F 40/06, H 01 F 27/06**

(21) Numéro de dépôt : **86401247.1**

(22) Date de dépôt : **10.06.86**

(54) Capteur inductif pour mesure de courant.

(30) Priorité : 28.06.85 FR 8509864

(43) Date de publication de la demande :
21.01.87 Bulletin 87/04

(45) Mention de la délivrance du brevet :
02.11.89 Bulletin 89/44

(84) Etats contractants désignés :
AT CH DE FR GB IT LI SE

(56) Documents cités :
DE-A- 2 432 919
FR-A- 2 507 811
27TH ELECTRONIC COMPONENTS CONFERENCE,
Arlington, VA, US, 16-18 mai 1977, pages 116-121;
S.G. JOHNSTON et al.: "Design and operation of a
flux-gate compass using a floating core"
PATENTS ABSTRACTS OF JAPAN, vol. 5, no. 23 (E-
45)[695], 12 février 1981; & JP-A-55 151 309 (MATSUS-
HITA DENKO K.K.) 25-11-1980

(73) Titulaire : TELEMECANIQUE
43-45, Boulevard Franklin Roosevelt
F-92504 Rueil-Malmaison Cedex (FR)

(72) Inventeur : Baurand, Gilles
72, rue Corneille
F-78360 Montesson (FR)
Inventeur : Fouret, René
19, rue Pierre Brossolette
F-92500 Rueil Malmaison (FR)
Inventeur : Rundsztuk, Marek
3, rue Jules Ferry
F-95880 Enghien les Bains (FR)

(74) Mandataire : Marquer, Francis et al
Cabinet Moutard 35, Avenue Victor Hugo
F-78960 Voisins le Bretonneux (FR)

## Description

La présente invention concerne un capteur inductif pour mesure de courant, notamment du type à ceinture de Rogowski, comportant plusieurs bobines reliées électriquement en série et disposées selon un contour polygonal de manière à entourer le conducteur sur lequel on souhaite effectuer la lecture de courant.

Le brevet FR No 2 507 811 décrit un tel capteur inductif de courant à plusieurs bobinages disposés selon un carré ou un rectangle dans un boîtier, les carcasses des bobinages étant soit indépendantes, soit solidarisées par pliage d'une seule pièce moulée en matière plastique, et pouvant être entourées par un blindage de protection non fermé sur lui-même. Le capteur permet de recueillir une tension induite dans les bobinages, cette tension étant une fonction linéairement proportionnelle à la dérivée du courant qui le traverse.

Par ailleurs, par le brevet japonais JP-A-55 15 1309, on a déjà proposé un dispositif de montage d'une carcasse de bobine selon lequel l'assemblage de la carcasse sur un support et la réalisation des connexions de la bobine peuvent être effectués simultanément à l'aide de moyens d'assemblage automatiques.

L'invention part de la constatation qu'un capteur inductif de courant du type susdit peut être également perfectionné en ce qui concerne son industrialisation, notamment son montage et sa connectique. Elle a notamment pour but de simplifier la réalisation d'un capteur inductif de courant, plus particulièrement en facilitant la connexion des bobines entre elles et avec un circuit électronique de traitement, ce dernier pouvant être intégré audit capteur.

Elle a également pour but de faciliter l'assemblage du capteur inductif par la réalisation d'un sous-ensemble capteur comprenant les bobines et leurs moyens de support et de connexion.

L'invention concerne un capteur de mesure inductif de courant, notamment à ceinture de Rogowski, comportant plusieurs bobines reliées électriquement en série et disposées selon un contour polygonal de manière à entourer le conducteur de puissance sur lequel on souhaite effectuer la lecture de courant, chaque bobine comprenant des nappes d'enroulements disposés sur une carcasse isolante.

Selon l'invention, les carcasses isolantes des bobines sont montées sur une première face d'un circuit imprimé muni d'un évidement sensiblement central de dimensions prédéterminées en fonction du calibre du conducteur de puissance ; chaque bobine comprend des éléments de connexion à une bobine voisine ou à un organe de connexion externe, les éléments de connexion associés à au moins deux bobines étant fixes au circuit imprimé ; ce circuit imprimé porte des pistes conductrices interconnectant les points de fixation des éléments de connexion entre eux ou aux organes de connexion externe.

Le capteur inductif réalisé de la sorte est particulièrement simple puisque le circuit imprimé assure à la fois une fixation mécanique des carcasses de bobines et une interconnexion électrique des bobines. Les connexions externes peuvent s'effectuer avantageusement en bénéficiant du circuit imprimé grâce à la présence sur celui-ci de pistes conductrices appropriées et de pattes de connexions externes soudées au circuit.

Chaque bobine porte, soit un bobinage à nombre pair de nappes d'enroulements, auquel cas les éléments de connexion sont situés d'un même côté de la carcasse, soit un bobinage à nombre impair de nappes d'enroulements, auquel cas les éléments de connexion sont situés de part et d'autre de la carcasse. Dans le premier cas, les pistes conductrices d'interconnexion d'éléments de connexion de bobines voisines ont une longueur sensiblement équivalente à celle de la carcasse. Dans le second cas, le circuit imprimé porte avantageusement une piste conductrice de neutralisation entourant sensiblement son évidement central et disposée électriquement en série et magnétiquement en opposition avec les enroulements de manière à neutraliser les effets perturbateurs des champs magnétiques extérieurs.

Une résistance d'ajustement peut de plus être rapportée sur le circuit imprimé afin de permettre l'étalonnage du capteur pour s'affranchir des dispersions de fabrication.

D'autres particularités et avantages de l'invention résulteront de la description faite ci-après d'un mode de réalisation non limitatif en regard des dessins annexés.

La figure 1 représente en élévation un capteur inductif de courant à ceinture de Rogowski conforme à l'invention ;

La figure 2 montre une vue de dessous en perspective éclatée du capteur ;

La figure 3 est une vue en coupe selon III-III du capteur de la figure 1 ;

La figure 4 représente en vue de côté le circuit imprimé porteur des corps de bobine ;

La figure 5 est une coupe partielle agrandie selon la ligne IV-IV de la figure 3 montrant l'assise d'une carcasse de bobine sur le circuit imprimé ;

La figure 6 est une vue du circuit imprimé selon la flèche F de la figure 4 ;

La figure 7 montre le schéma électrique correspondant.

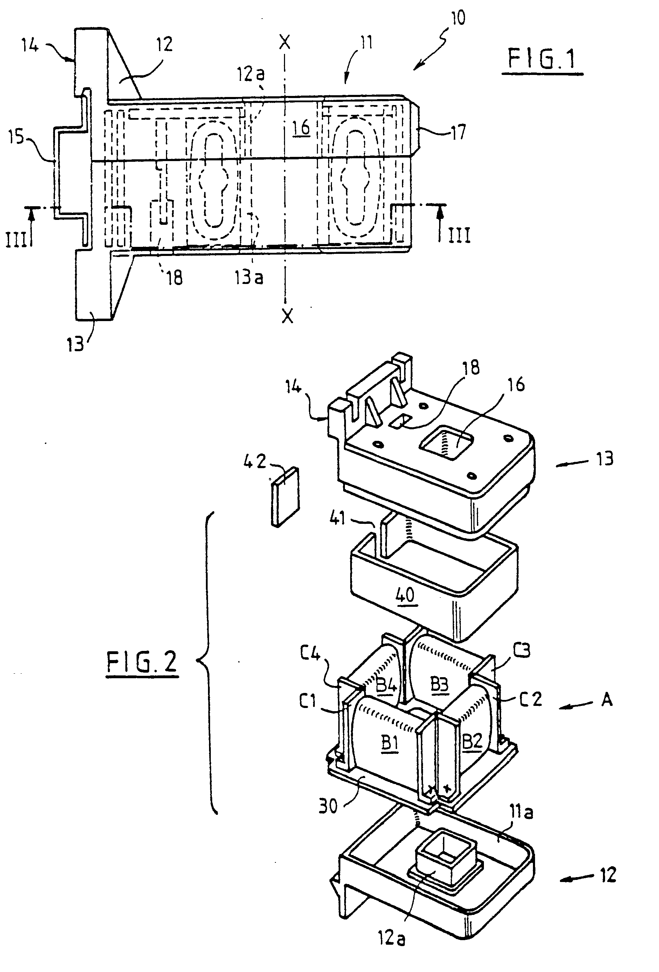

Le capteur inductif d'intensité 10 représenté sur la figure 1 présente un boîtier 11 qui se compose d'une enveloppe supérieure 12 et d'une enveloppe inférieure 13 ; les deux enveloppes 12, 13 sont mutuellement emboîtables et fixées par exemple par rivetage. Le boîtier comporte une face arrière 14 munie d'éléments de fixation à un support tel qu'un rail 15 ou une platine ; il comporte de plus un puits traversant 16 d'axe vertical X-X parallèle au plan de la face 14 de forme polygonale, présentement rectangulaire ou carré, de dimensions prédéterminées pour le passage du conducteur de puissance en forme de câble ou de barre dont on désire effectuer la lecture de courant. Le boîtier est, par ailleurs, équipé d'un porte-repère frontal 17 et d'une ouverture 18 dirigée parallèlement à l'axe X-X pour permettre le raccordement de conducteurs externes assurant la connexion du capteur avec un circuit électronique associé de traitement.

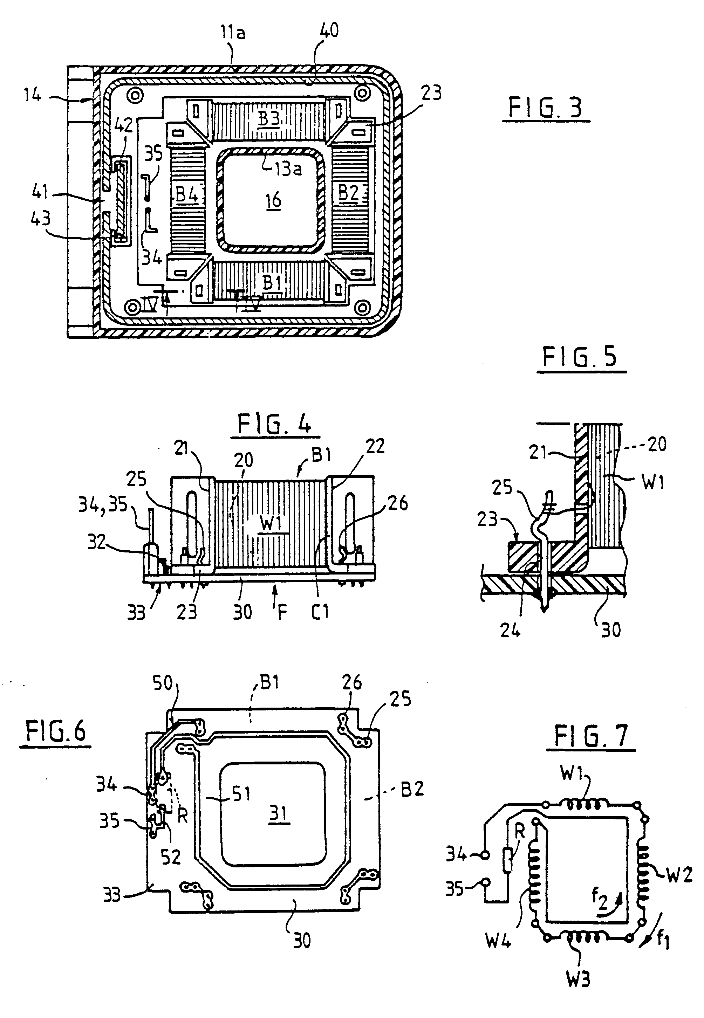

Comme on le voit sur la figure 2, le boîtier 11 loge un sous-ensemble de détection A constitué par quatre bobines identiques deux à deux B1-B4 disposées en rectangle ou en carré pour former une ceinture de Rogowski ; les bobines comprennent des nappes d'enroulements respectifs W1-W4 bobinées en nombre impair sur des carcasses isolantes C1-C4. Chaque carcasse isolante se présente (figures 3 et 4) sous la forme d'un noyau creux 20 se rattachant à des parois d'arrêt latérales 21, 22 ; chaque paroi 21, 22 est dotée d'un piètement 23 dans lequel est ménagé un orifice traversant 24 logeant un picot de connexion 25, 26. Le nombre d'enroulements de chaque bobine est impair de façon que l'entrée et la sortie de courant de la bobine s'effectuent près des deux parois opposées 21, 22. Les piètements 23 sont biseautés à 45° pour diminuer au maximum l'écartement des bobines adjacentes (voir figures 2 et 3).

Selon l'invention, les bobines B1-B4 sont montées sur un circuit imprimé 30 de forme générale rectangulaire ou carrée et muni d'un évidement central 31 de section rectangulaire ou carrée légèrement supérieure à celle du puits 16 de passage du conducteur de puissance.

Les carcasses C1-C4 sont disposées sur une première face 32 du circuit imprimé 30 de manière que les picots de connexion 25, 26 puissent être fixés à la deuxième face 33 du circuit imprimé 30. Celui-ci porte d'autre part, du même côté que les carcasses de bobines, deux pattes de connexion externe 34, 35 destinées à se loger dans l'ouverture 18 et une résistance d'étalonnage R. La fixation des picots 25, 26 et des pattes 34, 35 peut s'effectuer par passage à la vague.

L'agencement du circuit imprimé sera explicité plus loin en regard des figures 6 et 7.

Les enveloppes supérieure 12 et inférieure 13 du boîtier présentent respectivement des manchons 12a et 13a à contour sensiblement rectangulaire ou carré, mutuellement emboîtables pour déterminer intérieurement le puits 16 de passage du conducteur de puissance et extérieurement le logement du sous-ensemble capteur A à bobines B1-B4 et circuit imprimé 30. Le sous-ensemble A est ainsi centré sur l'axe X-X par l'emboîtement de l'évidement central 31 du circuit 30 sur l'un des manchons, tandis que d'autres conformations intérieures aux enveloppes 12, 13 peuvent également contribuer au centrage et au maintien du sous-ensemble.

Un blindage 40 est disposé dans le boîtier 11 du capteur 10 ; la paroi extérieure du blindage 40 est au contact de la cloison 11a du boîtier. Ce blindage est ouvert en 41 du côté de la face arrière 14 du boîtier, tandis qu'un élément de blindage complémentaire 42 est inséré en regard de l'ouverture 41 du blindage 40 dans des rainures de maintien 43 venues de moulage avec l'enveloppe 13.

La face de soudage 33 du circuit imprimé 30 présente des pistes telles qu'indiquées figure 6. La patte 34 de connexion externe est reliée par une piste 50 ménagée sur la face 33 au picot 25 de la bobine B1 ; l'autre picot 26 de la bobine B1 est relié par un point de soudure au picot 25 de la bobine B2 et ainsi de suite jusqu'au picot 26 de la bobine B4 qui est brasé sur une piste 51 ménagée sur la face 33 et contournant la quasi-totalité de l'évidement central 31 du circuit imprimé 30, de manière à être parcourue par le courant en sens opposé à la circulation du courant dans les bobines (cf. flèches $f_1$ et $f_2$ sur la figure 7).

Une résistance R d'étalonnage ou d'ajustement est reliée, d'une part, à la piste 51, d'autre part, à une piste 52 reliée à la deuxième patte de connexion externe 35.

On constate que l'assemblage du capteur selon l'invention consiste simplement à loger le blindage dans l'une des enveloppes, à mettre en place le sous-ensemble, à couler éventuellement une résine pour assurer une meilleure tenue aux chocs et vibrations du capteur et à riveter les enveloppes.

Le capteur inductif illustré est à ceinture de Rogowski, mais peut être constitué par tout autre capteur inductif de mesure de courant à bobines interconnectables disposées en polygone à nombre de côtés quelconque. Le circuit imprimé peut porter les composants électroniques assurant le traitement, c'est-à-dire notamment l'amplification et éventuellement l'intégration, du signal issu du capteur.

## Revendications

1. Capteur inductif de mesure de courant, notamment à ceinture de Rogowski, comportant :

plusieurs bobines (B1-B4) reliées électriquement en série et disposées selon un contour polygonal de manière à entourer le conducteur de puissance sur lequel on souhaite effectuer la lecture de courant,

chaque bobine comprenant des nappes d'enroulements (W1-W4) disposées sur une carcasse isolante (C1-C4),

caractérisé par le fait que :

les carcasses isolantes (C1-C4) des bobines sont disposées sur une première face (32) d'un circuit imprimé (30) muni d'un évidement central (31) de dimensions prédéterminées en fonction du calibre du conducteur de puissance,

chaque bobine comprend des éléments de connexion (25, 26) à une bobine voisine ou à un organe de connexion externe, les éléments de connexion (25) associés à au moins deux bobines étant fixés au circuit imprimé,

le circuit imprimé (30) porte des pistes conductrices (50, 52) interconnectant les points de fixation des éléments de connexion (25) entre eux ou aux organes de connexion externe (34, 35).

2. Capteur selon la revendication 1, caractérisé par le fait que le circuit imprimé (30) constitue simultanément une embase porteuse des carcasses isolantes (C1-C4) des bobines (B1-B4).

3. Capteur selon la revendication 1 ou 2, dont chaque bobine porte un nombre pair de nappes d'enroulement (W1-W4), caractérisé par le fait que les pistes conductrices du circuit imprimé (30) interconnectant les points de fixation d'éléments de connexion (25) de bobines voisines ont une longueur sensiblement équivalente à celle de la carcasse (C1-C4).

4. Capteur selon la revendication 1 ou 2, dont chaque bobine porte un nombre impair de nappes d'enroulements (W1-W4), caractérisé par le fait que les pistes conductrices du circuit imprimé (30) interconnectant les points de fixation d'éléments de connexion (25) de bobines voisines ont une faible longueur, tandis qu'il est prévu sur le circuit imprimé une piste conductrice (51) de neutralisation entourant sensiblement l'évidement central (31) et disposée électriquement en série et magnétiquement en opposition avec les enroulements (W1-W4).

5. Capteur selon l'une des revendications 1 à 4, caractérisé par le fait que le circuit imprimé (30) porte une résistance (R) d'ajustement reliée à ses pistes conductrices (51-52) pour permettre d'étalonner ladite sonde.

6. Capteur selon l'une des revendications 1 à 5, caractérisé par le fait que les bobines (B1-B4) et le circuit imprimé (30) constituent un sous-ensemble (A) disposé dans un boîtier isolant (11) logeant également un blindage ouvert (40) entourant les bobines et comprenant un manchon qui détermine un puits (16) pour le passage du conducteur de puissance et qui constitue un moyen de centrage du sous-ensemble.

7. Capteur selon l'une des revendications 1 à 6, caractérisé par le fait que le boîtier (11) se compose de deux enveloppes emboîtables (12, 13) dont l'une présente une ouverture (18) pour le passage d'organes (34, 35) de connexion externe fixés au circuit imprimé.

8. Capteur selon l'une des revendications 1 à 7, caractérisé par le fait que le boîtier (11) présente une face arrière (14) dotée d'éléments de fixation à un support normalisé de manière que l'axe (X-X) du puits (16) de passage pour le conducteur de puissance soit contenu dans un plan parallèle à celui de ladite face arrière.

9. Capteur selon l'une des revendications 1 à 8, caractérisé par le fait que le circuit imprimé (30) porte les composants électroniques assurant le traitement du signal issu dudit capteur.

## Claims

1. An inductive current measuring sensor particularly of the Robowski girdle type including :
   several coils (B1-B4) connected electrically together in series and disposed in a polygonal contour so as to surround the power conductor on which it is desired to make the current reading,
   each coil having layers of windings (W1-W4) disposed on an insulating carcase (C1-C4), characterized in that :
   the insulating carcases (C1-C4) of the coils are disposed on a first face (32) of a printed circuit (30) having a central recess (31) with dimensions predetermined as a function of the rating of the power conductor,
   each coil comprises elements for connection (25-26) to an adjacent coil or to an external connection member, the connection elements (25) associated with at least two coils being fixed to the printed circuit,
   the printed circuit (30) has conducting tracks (50, 52) interconnecting the fixing points of the connection elements (25) together or to external connection members (34, 35).

2. The sensor according to claim 1, characterized in that said printed circuit (30) forms simultaneously a carrier base for the insulating carcases (C1-C4) of the coils (B1-B4).

3. The sensor according to claim 1 or 2, each coil of which has an even number of winding layers (W1-W4), characterized in that said conducting tracks of the printed circuit (30) interconnecting the fixing points of connection elements (25) of adjacent coils have a length substantially equivalent to that of the carcase (C1-C4).

4. The sensor according to claim 1 or 2 in which each coil has an uneven number of winding layers (W1-W4), characterized in that said conducting tracks of the printed circuit (30) interconnecting the fixing points of connection elements (25) of adjacent coils have a short length, and on the printed circuit a conducting neutralization track (51) is provided surrounding substantially the central recess (31) and disposed electrically in series and magnetically in opposition with said windings (W1-W4).

5. The sensor according to one of the claims 1 to 4, characterized in that said printed circuit (30) has an adjustment resistor (R) connected to its conducting tracks (51-52) for calibrating said probe.

6. The sensor according to one of the claims 1 to 5, characterized in that the coils (B1-B4) and the printed circuit (30) form a subassembly (A) disposed in an insulating casing (11) also housing an open shield (40) surrounding the coils and comprising a sleeve which defines a well (16) for passing the power conductor therethrough and which forms a means for centering the subassembly.

7. The sensor according to one of the claims 1 to 6, characterized in that said casing (11) is formed of two cases (12, 13) which fit into one another one of which has an opening (18) for passing therethrough external connection members (34, 35) fixed to the printed circuit.

8. The sensor according to one of the claims 1 to 7, characterized in that said casing (11) has a rear face (14) with elements for fixing to a standardized support so that the axis (X-X) of the well (16) through which the power conductor passes is contained in a plane parallel to that of said rear face.

9. The sensor according to one of the claims 1 to 8, characterized in that said printed circuit (30) carries the electronic components for processing the signal from said sensor.

## Patentansprüche

1. Induktiver Sensor für Strommessung, insbesondere des Rogowskigürteltyps, mit

mehreren Spulen (B1-B4) die elektrisch in Reihe montiert und polygonartig angeordnet sind, sodass sie den Leiter umgeben, an dem der Strom abgelesen werden soll,

wobei jede Spule Wicklungslagen (W1-W4) enthält, die auf einem Isolierrahmen (C1-C4) angeordnet sind,

dadurch gekennzeichnet,

dass die Isolierrahmen (C1-C4) der Spulen auf einer ersten Seite (32) einer gedruckten Schaltung (30) angeordnet sind, die eine zentrale Aussparung (31) besitzt, deren Abmessungen je nach dem Kaliber des Stromleiters bestimmt werden,

jede Spule Elemente (25, 26) aufweist, um sie mit einer benachbarten Spule oder einem äusseren Verbindungsorgan zu verbinden, wobei die mindestens zwei Spulen zugeordneten Verbindungselemente (25) an der gedruckten Schaltung befestigt sind,

die gedruckte Schaltung (30) Leitbahnen (50, 52) aufweist, welche die Befestigungspunkte der Elemente (25) aneinander oder an äusseren Organen (34, 35) miteinander verbinden.

2. Sensor nach Anspruch 1, dadurch gekennzeichnet, dass die gedruckte Schaltung (30) gleichzeitig eine Trägerbasis für die Isolierrahmen (C1-C4) der Spulen (B1-B4) bildet.

3. Sensor nach Anspruch 1 oder 2, in dem jede Spule eine gerade Anzahl von Wicklungslagen (W1-W4) aufweist, dadurch gekennzeichnet, dass die Länge der Leitbahnen der gedruckten Schaltung (30), welche die Befestigungspunkte der Verbindungselemente (25) für benachbarte Spulen miteinander verbindet, im wesentlichen gleich der des Rahmens (C1-C4) ist.

4. Sensor nach Anspruch 1 oder 2, in dem jede Spule eine ungerade Zahl von Wicklungslagen (W1-W4) trägt, dadurch gekennzeichnet, dass die Leitbahnen der gedruckten Schaltung (30), welche die Befestigungspunkte von Verbindungselementen (25) für benachbarte Spulen eine geringe Länge besitzen, während auf der gedruckten Schaltung eine Neutralisationsleitbahn (51) vorgesehen ist, welche im wesentlichen die zentrale Aussparung (31) umgibt und die elektrisch in Reihe und magnetisch in Opposition im Verhältnis zu den Wicklungen (W1-W4) geschaltet ist.

5. Sensor nach einem der Ansprüche 1 bis 4, dadurch gekennzeichnet, dass die gedruckte Schaltung (30) einen Einstellwiderstand (R) aufweist, der mit ihren Leitbahnen (51-52) verbunden ist, um besagte Sonde zu eichen.

6. Sensor nach einem der Ansprüche 1 bis 5, dadurch gekennzeichnet, dass die Spulen (B1-B4) und die gedruckte Schaltung (30) ein Teilsystem (A) bilden, das in einem Isoliergehäuse (11) angeordnet ist, welches gleichzeitig eine offene Abschirmung (40) aufnimmt, welche die Spulen umgibt und einen Stutzen aufweist, der einen Schacht (16) für den Durchlass des Stromleiters und ein Zentriermittel für das Teilsystem bildet.

7. Sensor nach einem der Ansprüche 1 bis 6, dadurch gekennzeichnet, dass das Gehäuse (11) aus zwei ineinanderschiebbaren Hülsen (12, 13) besteht, deren eine eine Durchlassöffnung (18) für äussere, an der gedruckten Schaltung befestigte Verbindungsorgane (34, 35) besitzt.

8. Sensor nach einem der Ansprüche 1 bis 7, dadurch gekennzeichnet, dass das Gehäuse (11) eine rückwärtige Fläche (14) aufweist, mit Elementen zur Befestigung an einem genormten Träger, sodass die Achse (X-X) des Durchlasschachtes (16) für den Stromleiter sich in einer Ebene befindet, die parallel zur der Ebene der besagten rüchwärtigen Fläche verläuft.

9. Sensor nach einem der Ansprüche 1 bis 8, dadurch gekennzeichnet, dass die gedruckte Schaltung (30) die elektronischen Teile trägt, welche die Verarbeitung des vom besagtem Sensor abgegebenen Signals ermöglichen.

FIG.1

FIG.2

FIG.3

FIG.4

FIG.5

FIG.6

FIG.7

2